**Europäisches Patentamt**

**European Patent Office**

**Office européen des brevets**

(19)

(11) Publication number : **0 512 850 A1**

# (12) EUROPEAN PATENT APPLICATION

(21) Application number : **92304156.0**

(22) Date of filing : **08.05.92**

(51) Int. Cl.$^5$ : **H03K 19/003, H03K 19/013**

(30) Priority : **09.05.91 JP 135866/91**

(43) Date of publication of application :
**11.11.92 Bulletin 92/46**

(84) Designated Contracting States :
**DE FR GB**

(71) Applicant : **NEC CORPORATION**
**7-1, Shiba 5-chome Minato-ku**
**Tokyo 108-01 (JP)**

(72) Inventor : **Matumoto, Kouji Nec Corp.**
**7-1, Shiba 5-chome, Minato-ku**
**Tokyo (JP)**

(74) Representative : **Moir, Michael Christopher et al**
**MATHYS & SQUIRE, 10 Fleet Street**
**London EC4Y 1AY (GB)**

(54) **Active pull-down circuit.**

(57)  A reference voltage generating circuit which comprises transistor $Q_2$ and resistors $R_2$ and $R_3$ and transistor $Q_1$ are formed integrally in a current mirror circuits, and the collector potential of transistor $Q_2$ is used as the reference voltage. Thus, the present invention provides an active pull-down circuit capable of stabiliszing a steady state current which passes through the transistor ($Q_1$) for pull-down operation and reducing variations of the delay time.

**FIG. 6**

EP 0 512 850 A1

The present invention relates to an active pull-down circuit to be used as an output circuit of an NTL (non-threshold logic) circuit, and more particularly an active pull-down circuit intended to ensure a stable operation of the NTL circuit.

ECL (emitter coupled logic) circuits are widely used for their high speed operation in such equipment as main frames, LSI testers, measuring instruments, graphic terminals, etc. This ECL circuit is provided with a current changeover type logic circuit which is formed between a ground potential and a negative power supply potential $V_{EE1}$ (-4.5V or -5.2V) and an emitter follower circuit which is formed between a ground potential as an output circuit and a negative power supply potential $V_{EE2}$ (-2V). The emitter follower is disadvantageous in that the load drive ability, when the output changes from high to low, is inferior to that when the output changes from low to high since the emitter follower is terminated with a resistor. Lately, therefore, for the purpose of improving the delay time due to a load capacity, an active pull-down type emitter follower using capacitors has been proposed. In pursuit of high speed operation, a combination circuit of an NTL circuit which quickly operates as a simple inverter gate to which an active pull-down type emitter follower circuit is added has been proposed (Tanabe et. al., pages 5-209, C-645 "Review of High Speed Bipolar Logic Circuit SPL", 1990, Spring National Convention of Electronic Information Communications Society, and Tanabe et. al., pages 21-25, ED90-62, 1CD90-87 "Review of High Speed and Low Power Consumption Circuit SPL", Shingaku Giho).

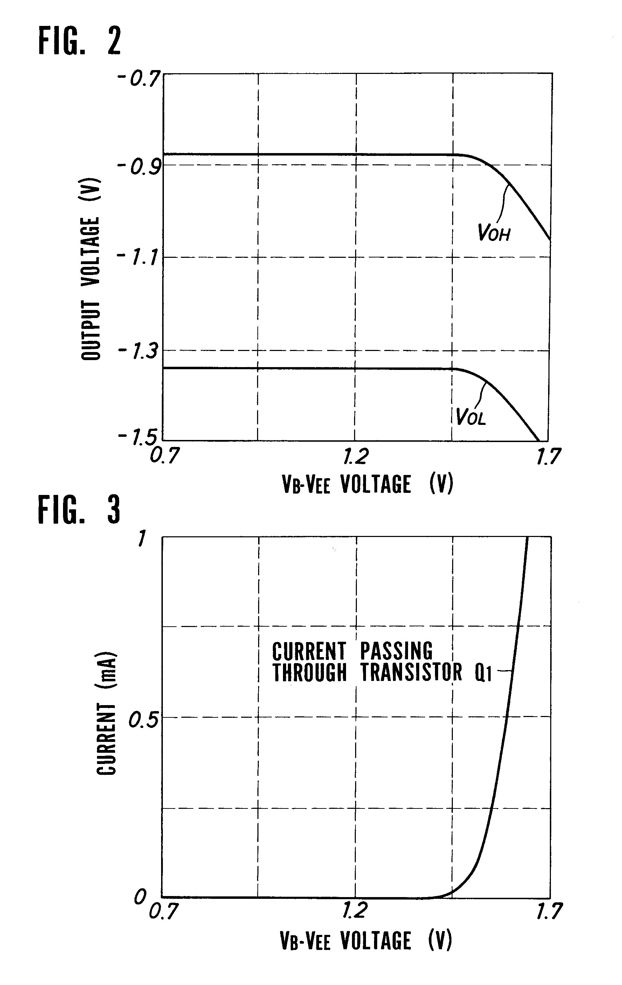

Fig.1 is a circuit diagram showing the NTL circuit of the prior art which is provided with an active pull-down circuit as an output circuit. Resistor $R_4$, transistor $Q_3$ and resistor $R_5$ are connected in series between the power source $V_{CC}$ at the high potential side and the power source $V_{EE}$ at the low potential side, and the input terminal IN is connected to the base of transistor $Q_3$. A phase or voltage dividing circuit is composed of these resistor $R_4$, transistor $Q_3$ and resistor $R_5$. Transistor $Q_4$ and resistor $R_{11}$ are connected in series between the power source $V_{CC}$ and the power source $V_{EE}$, the output terminal OUT is connected to the emitter of transistor $Q_4$, and the collector of transistor $Q_3$ is connected to the base of transistor $Q_4$. The emitter follower circuit is composed of these transistor $Q_4$ and resistor $R_{11}$. In this case, an NTL circuit is formed by driving the emitter follower with an output of the high potential side.

The active pull-down circuit is constructed as described below. Specifically, transistor $Q_{12}$ and resistor $R_{12}$ are connected in series between the power source $V_{CC}$ and the power source $V_{EE}$ and the reference potential $V_B$ is applied to the base of transistor $Q_{12}$. An emitter follower type reference voltage generating circuit is formed with these transistor $Q_{12}$, reference potential $V_B$ and resistor $R_{12}$. Transistor $Q_{11}$ for

pull-down operation is connected between the output terminal OUT and the power source $V_{EE}$, and the base of transistor $Q_{11}$ is connected to the output terminal (emitter of transistor $Q_{12}$) of the reference voltage generating circuit. Capacitor $C_{11}$ is connected between the output terminal at the low potential side of the phase dividing circuit and the connection point of the output terminal of the reference voltage generating circuit and the base of transistor $Q_{11}$.

The following describes the operation of the above described NTL circuit according to the prior art. When a high potential input signal $V_{IH}$ is supplied to the input terminal IN, a current $I_H (Q_3)$ flows through resistor $R_4$, transistor $Q_3$ and resistor $R_5$. This current $I_H (Q_3)$ is expressed by equation 1 given below. Wherein $V_F (Q_1)$ is a forward operating voltage of an optional transistor $Q_1$ :

$$I_H (Q_3) = (V_{IH} - V_F (Q_3) - V_{EE})/R_5 \quad (1)$$

When current $I_H (Q_3)$ flows through resistor $R_4$, voltage does appear and a low potential output signal $V_{OL}$ is output to the output terminal OUT through the emitter follower circuit. This output signal $V_{ol}$ is expressed by equation (2) given below.

$$V_{ol} = V_{cc} - (V_{IH} - V_F (Q_3) - V_{EE}) \times R_4/R_5 - V_F (Q_4) \quad (2)$$

When a low potential input signal $V_{IL}$ is supplied to the input terminal IN, current $I_L (Q_3)$ flows in resistor $R_4$, transistor $Q_3$ and resistor $R_5$. This current $I_L (Q_3)$ is expressed by equation 3 given below.

$$I_L (Q_3) = (V_{IL} - V_F (Q_3) - V_{EE}) / R_5 \quad (3)$$

In this case, current $I_L (Q_3)$ is smaller than $I_H (Q_3)$, a drop of the potential in resistor $R_4$ is small and a high potential output signal $V_{OH}$ is output to the output terminal OUT through the emitter follower. This output signal $V_{OH}$ is expressed by equation (4) given below.

$$V_{OH} = V_{CC} - (V_{IL} - V_F (Q_3) - V_{EE}) \times R_4 /R_5 - V_F (Q_4) \quad (4)$$

A difference of the above described NTL circuit from conventional NTL circuits is that an active pull-down circuit is added to the former. The following describes the operation of the active pull-down circuit. In the normal mode where the output is high or low, a specified potential $\{V_B - V_F (Q_{12})\}$ is supplied to the base of transistor $Q_{11}$ from the reference voltage generating circuit which comprises transistor $Q_{12}$, reference potential $V_B$ and resistor $R_{12}$. This potential $\{V_B - V_F (Q_{12})\}$ is optimal if it is set so that a small current (for example, a few $\mu$ A) flows through transistor $Q_{11}$ for pull-down operation, and expressed by eqation (5) given below.

$$V_B - V_F (Q_{12}) - V_{EE} \fallingdotseq v_F (Q_{11}) \quad (5)$$

In a transient period when the input signal changes from low to high, capacitor $C_{11}$ is charged through transistor $Q_3$. At this time, part of the charging current in capacitor $C_{11}$ is amplified as the base current of transistor $Q_{11}$ and a large current is transiently discharged from a load capacity. Thus, the change of the output signal from high to low is quickened by providing the active pull-down circuit.

However, in the above described active pull-down circuit of the prior art, there is a problem that it is difficult to set the reference potential $V_B$ so that a small current flows in transistor $Q_{11}$ for pull-down operation in a normal mode where the output is high or low and stably maintains this reference potential $V_B$. In other words, even in the case that the reference potential $V_B$ is supplied from outside of the LSI or that the reference potential generating circuit is provided in the LSI, it is difficult to maintain the same potential difference over the whole surface of the semiconductor chip by decreasing the potential of the wiring for the $V_B$ power source or increasing the potential of the wiring for the $V_{EE}$ power source on the semiconductor chip. When the potential difference between the $V_B$ power source wiring and the $V_{EE}$ power source wiring increases, the amount of current which constantly flows through transistor $Q_{11}$ increases and the power consumption also increases. On the contrary, when the potential difference between the $V_B$ power source wiring and the $V_{EE}$ power source wiring decreases, transistor $Q_{11}$ is completely off in the normal mode and the starting of pull-down operation is delayed and therefore the delay time increases when the output signal changes from high to low.

Fig.2 is a graph showing the relationship between the output voltage and the $V_B$ -$V_{EE}$ voltage in the NTL circuit shown in Fig. 1, Fig. 3 is a graph showing the relationship between the current which flows through transistor $Q_{11}$ for pull-down operation and the $V_B$ -$V_{EE}$ voltage in the NTL circuit shown in Fig. 1, and Figs. 4 and 5 are respectively waveform diagrams showing the relationship between the output signal and the $V_B$ $V_{EE}$ voltage at the fall of the output and the rise of the output in the NTL circuit shown in Fig. 1. Fig. 2 to 5 show the results obtained from the SPICE simulation and the parameters used in this simulation are $R_{11}$ =3.05k$\Omega$, $R_{12}$ = 10k$\Omega$, $R_4$ =$R_5$ = 2.15k$\Omega$, $C_{11}$ =0.1 pF, Tj (temperature)= 75°C, $V_{CC}$ =0V, $V_{EE}$ =-2.2V and $V_B$ =(variable parameter).

As known from Fig.s 2 and 3, as the $V_B$ -$V_{EE}$ increases, the current which flows through transistor $Q_{11}$ for pull-down operation increases, power consumption also increases and the output voltages of output signals $V_{OH}$ and $V_{OL}$ are lowered.

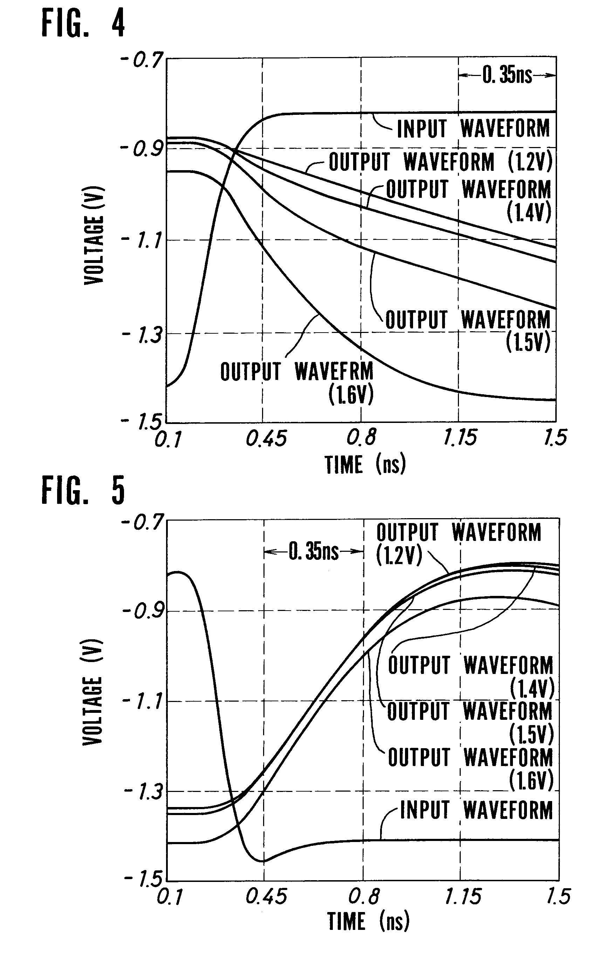

As known from Figs. 4 and 5, as the $V_B$ -$V_{EE}$ decreases, the delay time increases the output signal changes from high to low while the delay time is not nearly affected when the output signal changes from low to high.

An object of the present invention is to solve such a problem and to provide an active pull-down circuit capable of stabilizing a regular current which flows through a transistor for pull-down operation and reducing a variation of the delay time.

An active pull-down circuit in accordance with a first aspect of the present invention comprises a reference voltage generating circuit formed in a current mirror circuit, wherein the reference voltage generating circuit comprises a transistor the collector potential of which is used as the reference voltage.

The collector and the base of the transistor may be connected together through a resistor.

In another aspect of the present invention, an active pull-down circuit comprises a dividing circuit connected between a first power source and a second source;

a reference voltage generating circuit connected between said first and second power sources;

a first transistor having a collector, a base and an emitter; said collector being connected to an output terminal; said base being connected to an output terminal of said reference voltage generating circuit through a first resistor; said emitter being connected to said first power source; and

a capacitor connected between a connection point of the base of said first transistor and said first resistor and an output terminal of a low potential side of said dividing circuit, said reference voltage generating circuit being composed of a second transistor having a collector, a base and an emitter; said collector being connected to said second power source through a second resistor; said base being connected to its own collector through a third resistor; and said emitter being connected to said first power source.

The reference voltage generating circuit may comprise the second transistor employing the second and third resistors, the base of the first transistor for pull-down operation being connected to the output terminal (the collector of the second transistor) of the above described reference voltage generating circuit through the first resistor. In other words, a current mirror circuit is formed with the reference voltage generating circuit and the first transistor. The output of the low potential side of the phase dividing circuit is adapted to drive the capacitor connected to the base of the first transistor. The first and second resistors are provided to prevent oscillation.

In the active pull-down circuit constructed as described above, the capacitor is charged with the output at the low potential side of the phase dividing circuit in the transient period of the input signal. In this case, part of the charging current of the capacitor is amplified as the base current of the first transistor. With this, a load capacity of the output terminal is withdrawn through the first transistor and therefore the load capacity can be transiently discharged with a large current. The present invention allows to maintain the base-emitter voltage of the first transistor at a fixed level even when the potential of the first power source rises in order to integrate the reference voltage generating circuit and the first transistor for pull-down operation in the current mirror circuit and use the collector potential of the second transistor as the reference potential. Thus, a regular current which passes through the first transistor for pull-down operation can be stabilized and variations of the delay time can be reduced.

Accordingly, the active pull-down circuit is suitable for an output circuit of the NTL circuit. Particularly, if the ECL circuit and the NTL circuit are formed on the same semiconductor board, it is preferable to use the active pull-down circuit as the output circuit of the NTL circuit for entering an ECL level signal and supplying its own output to the next stage ECL circuit.

In the present invention, the potential of the first power source is preferably set to an inter mediate level between the maximum potential and the minimum potential of the ECL circuit, and the potential of the second power source is preferably set to the maximum potential of the ECL circuit.

Reference will now be made, by way of example, to the accompanying drawings; in which:-

Fig.1 is a circuit diagram showing the NTL circuit employing the conventional active pull-down circuit;

Fig.2 is a graph showing the relationship between the output voltage and the $V_B$ -$V_{EE}$ voltage in the NTL circuit shown in Fig.1;

Fig.3 is a graph showing the relationship between the current which flows through the transistor for pull-down operation and the $V_B$ -$V_{EE}$ voltage in the NTL circuit shown in Fig. 1;

Fig.4 is a waveform diagram showing the relationship between the output signal upon the fall of output and the $V_B$ $V_{EE}$ voltage in the NTL circuit shown in Fig. 1;

Fig.5 is a waveform diagram showing the relationship between the output signal upon the rise of output and the $V_B$ $V_{EE}$ voltage in the NTL circuit shown in Fig. 1;

Fig.6 is a circuit diagram showing the active pull-down circuit of the first embodiment according to the present invention;

Fig.7 is a circuit diagram showing the NTL circuit employing the active pull-down circuit in accordance with the first embodiment;

Fig.8 is a circuit diagram showing the NTL circuit employing the active pull-down circuit in accordance with the second embodiment;

Fig.9 is a waveform diagram showing the relationship between the delay time upon the fall of output and the $V_{EE}$ voltage in the conventional NTL circuit; and

Fig.10 is a waveform diagram showing the relationship between the delay time upon the fall of output and the $V_{EE}$ voltage in the NTL circuit in accordance with the first embodiment.

The following describes the embodiments according to the present invention, by reference to the accompanying drawings.

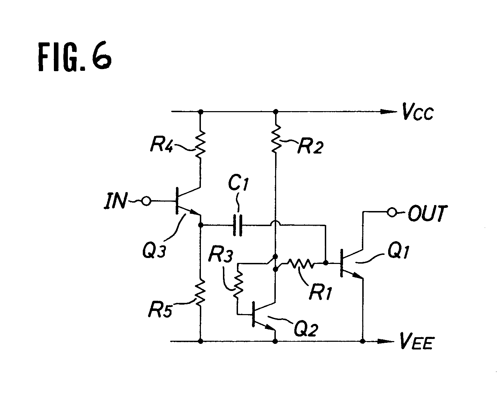

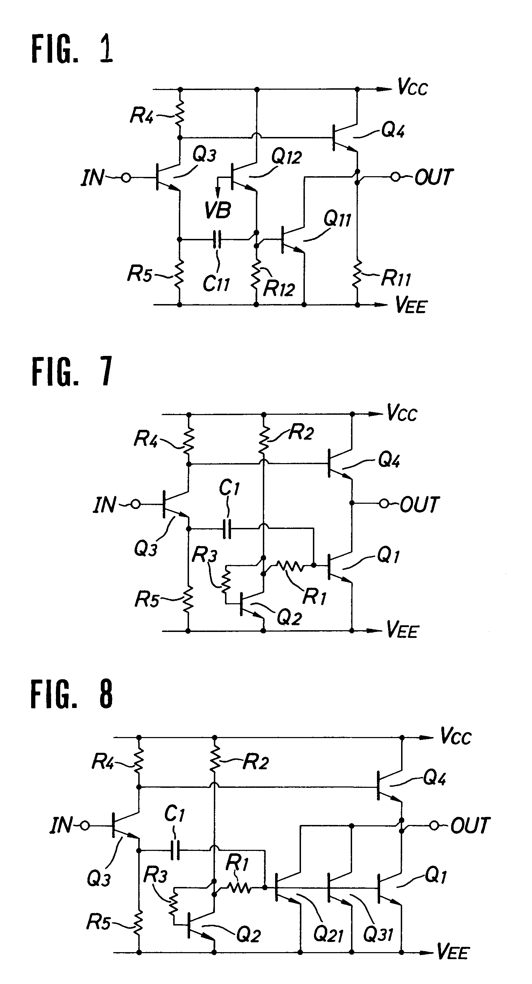

Fig.6 is a circuit diagram showing the active pull-down circuit in accordance with the first embodiment of the present invention and Fig. 7 is a circuit diagram showing an NTL circuit employing the active pull-down circuit according to this embodiment. The construction of the NTL circuit according to this embodiment differs in the point that the circuit is terminated with the constant current source composed of the current mirror type transistor $Q_1$ from the point that transistor $Q_4$ for the emitter follower in the prior art example shown inFig.1 isterminated with a resistor. Accordingly, the detailed description of the same parts shown in Fig. 6 and 7 as those shown in Fig. 1, which are given the same symbols, is omitted.

The active pull-down circuit is constructed as described below. In other words, resistor $R_4$, transistor $Q_3$ and resistor $R_5$ are connected in series between the power source $V_{CC}$ of the high potential side and the power source $V_{EE}$ of the low potential side, and the input terminal IN is connectd to the base of transistor $Q_3$. The phase or voltage dividing circuit is composed of these resistor $R_4$, transistor $Q_3$ and resistor $R_5$ . Resistor $R_2$ and transistor $Q_2$ are connected in series between the power source $V_{CC}$ and the power source $V_{EE}$ . The base of this transistor $Q_2$ is connected to its own collector through resistor $R_3$ . Thus, the reference voltage generating circuit is formed with transistor $Q_2$ employing resistors $R_2$ and $R_3$ . The collector of transistor $Q_1$ for pull-down operation is connected to the output terminal OUT, the emitter is connected to the power source $V_{EE}$ and the base is connected to the output terminal (the collector of transistor $Q_2$ ) of the reference voltage generating circuit through resistor $R_1$ . The current mirror circuit is composed of transistor $Q_1$ and the reference voltage generating circuit. Resistors $R_1$ and $R_3$ are provided to prevent oscillation. Capacitor $C_1$ is connected between the connection point of the base of transistor $Q_1$ and resistor $R_1$ and the output terminal (the emitter of transistor $Q_3$) of the low potential side of the phase dividing circuit, and the output of the low potential side of the phase dividing circuit drives capacitor $C_1$.

Thus, the NTL inverter circuit employing the active pull-down circuit according to this embodiment can be formed by connecting transistor $Q_4$ between the power source $V_{CC}$ and the output terminal OUT and the base of this transistor $Q_4$ to the collector of transistor $Q_3$ .

The following describes the operation of the above described active pull-down circuit. The description of the operation of the NTL circuit is omitted since it is the same as the prior art except that transistor $Q_4$ for the emitter follower is terminated and operated with the constant current source for transistor $Q_1$ employing the current mirror circuit.

In this case, capacitor $C_1$ is charged through transistor $Q_3$ in the transient period when an input signal to the input terminal IN changes from low to high. At this time, part of the charging current of capacitor $C_1$

is amplified as the base current of transistor $Q_1$. Then, the load capacity of the output terminal OUT is withdrawn through transistor $Q_1$, and therefore the load capacity can be transiently discharged with a large current.

According to this embodiment, the base-emitter voltage of transistor $Q_1$ can be maintained at a fixed level despite a rise of the potential of the wiring for the power source $V_{EE}$ since the reference voltage generating circuit and transistor $Q_1$ for pull-down operation are integrated in the current mirror circuit and the collector potential of transistor $Q_2$ is utilized as the reference potential. Then, the regular current which passes through transistor $Q_1$ for pull-down operation can be stabilized and variations of the delay time can be reduced.

Fig.8 is a circuit diagram showing the NTL circuit employing the active pull-down circuit according to the second embodiment of the present invention. Differing from the first embodiment, this embodiment is intended to provide a plurality of transistors for pull-down operation and therefore the parts shown in Fig. 8 as those in Fig. 7 are given the same symbols and the detailed description of these parts is omitted.

Transistor $Q_{21}$ and $Q_{31}$ are connected in parallel and the bases of transistors $Q_1$, $Q_{21}$ and $Q_{31}$ are connected to the collector of transistor $Q_2$ through resistor $R_1$.

According to this embodiment, the current value of transistor $Q_2$ can be reduced to 1/3 as compared to that of the first embodiment if the total current which flows through a group of transistors is set to be the same as that in the first embodiment since this group of three transistors $Q_1$, $Q_{21}$ and $Q_{31}$ are connected in parallel. Therefore, power consumption can be reduced.

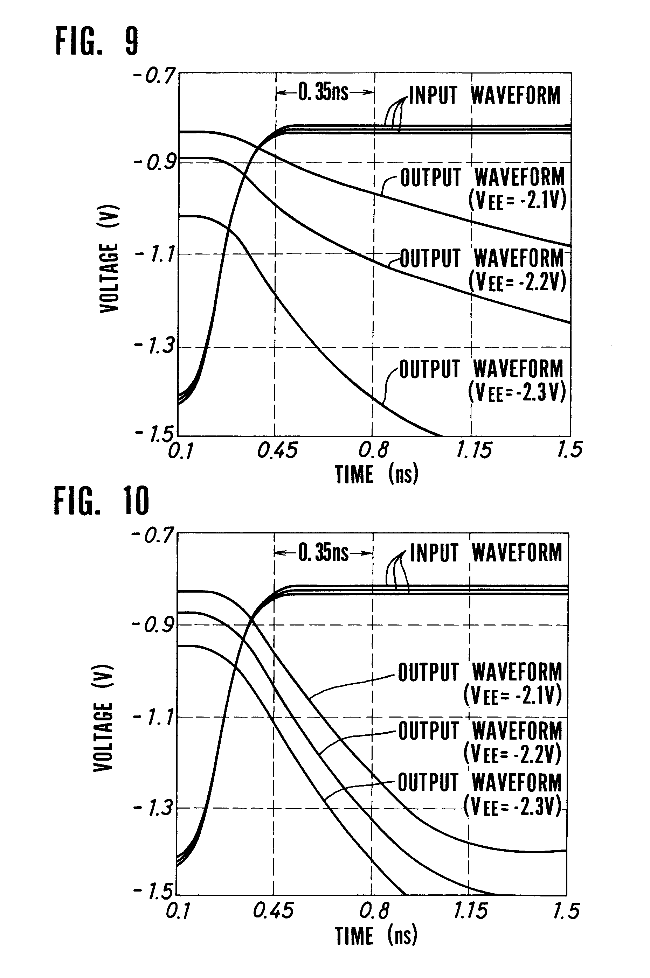

Figs. 9 and 10 are respectively a waveform diagram showing the relationship of the delay time and the $V_{EE}$ voltage upon the fall of output in the conventional NTL circuit (see Fig. 1) and the NTL circuit in accordance with the first embodiment (see Fig.7). Fig.s 9 and 10 show the results obtained from the SPICE simulation, and the parameters used in this simulation are shown below. Specifically, in case of the NTL circuit shown in Fig.7, the parameters are $R_1=R_2=R_3=10k\Omega$, $R_4=R_5=2.15$ k$\Omega$, $C_1=0.1$ pF, Tj (temperature)=75°C, $V_{CC}$=OV, and $V_{EE}$=-2.1/ -2.2/ -2.3. In case of the NTL circuit shown in Fig.9, the parameters are $R_{11}$=3.05k$\Omega$, $R_{12}$= 10k$\Omega$, $R_4$ =$R_5$ = 2.15 k$\Omega$, $C_{11}$=0.1 pF, Tj (temperature)=75 °C, $V_{CC}$=OV, $V_{EE}$ =-2.1/ -2.2/ -2.3V and $V_B$ =-0.7V.

As shown in Figs. 9 and 10, the delay time changes less even though the $V_{EE}$ voltage changes in the NTL circuit according to the first embodiment. On the other hand, in the conventional NTL circuit, the delay time substantially increases when the $V_{EE}$ rises and the $V_B$ -$V_{EE}$ voltage reduces.

As described above, according to the present invention, the conventional power supply for the reference potential is not required since the reference voltage generating circuit and the first transistor for pull-down operation are integrally formed in the current mirror circuit and the collector potential of the second transistor is used and the base-emitter voltage of the first transistor can be held at a fixed level even though the potential of the first power source increases. Thus, the steady state current which flows through the first transistor for pull-down operation can be stabilized and variations of the delay time can be reduced. Accordingly, the active pull-down circuit in accordance with the present invention is suitably used as the output means of the NTL circuit.

## Claims

1. An active pull-down circuit for stabilizing a steady state current passing through a transistor for pull-down operation comprising a reference voltage generating circuit ($Q_2,R_2,R_3$) formed in a current mirror circuit, wherein the reference voltage generating circuit comprises a transistor ($Q_2$) the collector potential of which is used as the reference voltage.

2. An active pull-down circuit in accordance with Claim 1 wherein the collector and the base of the transistor ($Q_2$) are connected together through a resistor ($R_3$).

3. An active pull-down circuit comprising:
   a dividing circuit ($R_4,Q_3,R_5$) connected between a first power source $V_{CC}$ and a second source $V_{EE}$;
   a reference voltage generating circuit ($Q_2,R_2,R_3$) connected between said first and second power sources;
   a first transistor ($Q_1$) having a collector, a base and an emitter; said collector being connected to an output terminal; said base being connected to an output terminal of said reference voltage generating circuit through a first resistor ($R_1$); said emitter being connected to said first power source; and
   a capacitor ($C_1$) connected between a connection point of the base of said first transistor and said first resistor and an output terminal of a low potential side of said dividing circuit, said reference voltage generating circuit being composed of a second transistor ($Q_2$) having a collector, a base and an emitter; said collector being connected to said second power source through a second resistor ($R_2$); said base being connected to its own collector through a third resistor ($R_3$); and said emitter being connected to said first power source.

4. An active pull-down circuit in accordance with Claim 3, wherein a plurality of said first transistors ($Q_{21}$,$Q_{31}$) are connected in parallel.

5. A non threshold logic circuit embodying as its output circuit an active pull-down circuit according to any preceding claim .

# FIG. 2

OUTPUT VOLTAGE (V)

$V_{OH}$

$V_{OL}$

$V_B$-$V_{EE}$ VOLTAGE (V)

# FIG. 3

CURRENT (mA)

CURRENT PASSING
THROUGH TRANSISTOR $Q_1$

$V_B$-$V_{EE}$ VOLTAGE (V)

# FIG. 4

# FIG. 5

FIG. 6

# FIG. 1

# FIG. 7

# FIG. 8

# FIG. 9

# FIG. 10

European Patent
Office

**EUROPEAN SEARCH REPORT**

Application Number

EP 92 30 4156

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | EP-A-0 432 577 (KABUSHIKI KAISHA TOSHIBA) * column 2, lines 13-18; column 4, lines 29-36; figure 2; column 4, line 55 - column 5, line 8; figure 4 * | 1 | H 03 K 19/003 H 03 K 19/013 |
| P,Y | | 3,5 | |
| D,Y | SPRING NATIONAL CONVENTION OF ELECTRONIC INFORMATION COMMUNICATIONS SOCIETY 1990, pages 5-209, C-645; M. TANABE et al.: "High Speed Bipolar Logic Circuit: SPL" * figure 1 * | 3,5 | |
| A | US-A-4 673 867 (W.F. DAVIS) * figure; abstract * | 1 | |
| P,X | US-A-5 059 827 (M. NGHIEM PHAN et al.) * abstract; column 6, line 54 - column 7, line 11; figures 4,2 * | 1,2 | |
| A | FR-A-2 641 143 (THOMSON COMPOSANTS MILITARIES ET SPATIAUX) * figure 2; page 6, line 14 - page 7, line 32; claims 1-3 * | 1 | TECHNICAL FIELDS SEARCHED (Int. Cl.5) G 05 F 3/26 H 03 K 19/003 H 03 K 19/013 |
| A | US-A-4 680 480 (D.F. HOPTA) * figure 2; column 15, line 9 - column 6, line 17 * | 1 | |
| A | EP-A-0 293 833 (KABUSHIKI KAISHA TOSHIBA) * figure 1; abstract * -/- | 1 | |

The present search report has been drawn up for all claims

| Place of search | Date of completion of the search | Examiner |
|---|---|---|
| BERLIN | 03-07-1992 | ARENDT M |

## EUROPEAN SEARCH REPORT

European Patent
Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | PATENT ABSTRACTS OF JAPAN vol. 15, no. 205 (P-1206), 27 May 1991; & JP - A - 3052193 (HITACHI LTD) 06.03.1991 | 1 | |
| A | PATENT ABSTRACTS OF JAPAN vol. 14, no. 467 (E-0989), 11 October 1990; & JP - A - 2190026 (HITACHI LTD) 26.07.1990 | 1 | |
| A | PATENT ABSTRACTS OF JAPAN vol. 3, no. 125 (E-145), 19 October 1979; & JP - A - 54 102961 (FUJITSU K.K.) 13.08.1979 | 1 | |
| A | PATENT ABSTRACTS OF JAPAN vol. 11, no. 285 (P-616)(2732), 16 Spetember 1987; & JP - A - 6280715 (HITACHI LTD) 14.04.1987 | 1 | |
| P,A | EP-A-0 463 890  (NEC CORPORATION) * whole document * | 1,2 | |
| P,A | EP-A-0 465 167  (NEC CORPORATION) * figure 2; column 3, line 44 - column 5, line 3 * | 1,5 | TECHNICAL FIELDS SEARCHED (Int. Cl.5) |
| A | EP-A-0 103 768  (SIEMENS AKTIENGESELLSCHAFT) * figure 1; abstract * | 2 | |

The present search report has been drawn up for all claims

| Place of search | Date of completion of the search | Examiner |
|---|---|---|
| BERLIN | 03-07-1992 | ARENDT M |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P0401)